(19) **Europäisches Patentamt**
**European Patent Office**
**Office européen des brevets**

(11) **EP 2 641 304 B1**

(12) **FASCICULE DE BREVET EUROPEEN**

(45) Date de publication et mention de la délivrance du brevet:
**03.12.2014 Bulletin 2014/49**

(21) Numéro de dépôt: **11799739.5**

(22) Date de dépôt: **18.11.2011**

(51) Int Cl.:
**H01S 5/026** *(2006.01)*  **G02B 6/293** *(2006.01)*

(86) Numéro de dépôt international:
**PCT/FR2011/000611**

(87) Numéro de publication internationale:
**WO 2012/066200 (24.05.2012 Gazette 2012/21)**

(54) **LASER HÉTÉROGÈNE À EFFICACITÉ ÉLEVÉE ET PROCÉDÉ DE FABRICATION DU LASER**

HETEROGENER HOCHLEISTUNGSLASER UND VERFAHREN ZUR HERSTELLUNG DES LASERS

HETEROGENEOUS LASER WITH HIGH EFFICIENCY AND METHOD OF MANUFACTURING THE LASER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.11.2010 FR 1004493**

(43) Date de publication de la demande:
**25.09.2013 Bulletin 2013/39**

(73) Titulaire: **Commissariat à l'Énergie Atomique et aux Énergies Alternatives 75015 Paris (FR)**

(72) Inventeurs:
  • **BEN BAKIR, Badhise**
    **F-38590 Brézins (FR)**
  • **OLIVIER, Nicolas**
    **F-38470 Têche (FR)**
  • **FEDELI, Jean-Marc**
    **F-38120 Saint-Egrève (FR)**

(74) Mandataire: **Talbot, Alexandre et al Cabinet Hecké Europole, BP 1537 10, rue d'Arménie 38025 Grenoble Cedex 1 (FR)**

(56) Documents cités:
  • **B. BEN BAKIR ET AL: "Electrically driven hybrid Si/III-V lasers based on adiabatic mode transformers", PROCEEDINGS OF SPIE, vol. 7719, 1 avril 2010 (2010-04-01), pages 77191F-77191F-9, XP055000619, ISSN: 0277-786X, DOI: 10.1117/12.858889**
  • **MATTHEW N SYSAK ET AL: "Reduction of hybrid silicon laser thermal impedance using poly Si thermal shunts", GROUP IV PHOTONICS (GFP), 2010 7TH IEEE INTERNATIONAL CONFERENCE ON, IEEE, PISCATAWAY, NJ, USA, 1 septembre 2010 (2010-09-01), pages 296-298, XP031806882, ISBN: 978-1-4244-6344-2**
  • **ALEXANDER W. FANG: "Heterogeneous integration of silicon and AlGaInAs for a silicon evanescent laser", PROCEEDINGS OF SPIE, vol. 6133, 1 janvier 2006 (2006-01-01), pages 61330W-61330W-8, XP055000679, ISSN: 0277-786X, DOI: 10.1117/12.660735**
  • **HSU-HAO CHANG ET AL: "1310nm silicon evanescent laser", OPTICS EXPRESS, vol. 15, no. 18, 1 janvier 2007 (2007-01-01), page 11466, XP055000688, ISSN: 1094-4087, DOI: 10.1364/OE.15.011466**
  • **XIANKAI SUN ET AL: "Hybrid electrically pumped evanescent Si/InGaAsP lasers", OPTICAL FIBER COMMUNICATION - INCUDES POST DEADLINE PAPERS, 2009. OFC 2009. CONFERENCE ON, IEEE, PISCATAWAY, NJ, USA, 22 mars 2009 (2009-03-22), pages 1-3, XP031467823, ISBN: 978-1-4244-2606-5 & XIANKAI SUN ET AL: "electrically pumped hybrid evanescent Si/InGaAsP lasers", OPTICS LETTERS, OSA, OPTICAL SOCIETY OF AMERICA, WASHINGTON, DC, US, vol. 34, no. 9, 1 mai 2009 (2009-05-01), pages 1345-1347, XP001523967, ISSN: 0146-9592**

EP 2 641 304 B1

- **DI LIANG ET AL: "100 mm integration of III-V and silicon-on-insulator wafers for the realization of distributed feedback silicon evanescent lasers", PROCEEDINGS OF SPIE, vol. 7135, 1 janvier 2008 (2008-01-01), pages 71351O-71351O-7, XP055000692, ISSN: 0277-786X, DOI: 10.1117/12.804544**

**Description**

**Domaine technique de l'invention**

L'invention est relative à un laser comportant :

- un amplificateur à hétérostructure de type III-V, agencée pour générer des photons,
- un guide d'onde couplé optiquement à l'amplificateur, et comportant une section en forme de créneau dont le sommet est proximal de l'amplificateur, le sommet du créneau et les flancs latéraux du créneau étant recouverts par une couche d'un matériau diélectrique au voisinage de l'amplificateur.

**État de la technique**

La photonique sur silicium (CMOS) adresse de nombreux domaines d'application tels que les interconnexions optiques dans les circuits intégrés, les télécommunications, la biophotonique, etc.

L'intégration de matériaux de type III-V avec du silicium est à présent considérée comme une approche permettant d'apporter des caractéristiques d'émission jusqu'alors inaccessibles au silicium.

Le document « A distributed Bragg Reflector Silicon Evanescent Laser » de Alexander W. Fang et al. publié dans IEEE Photonics Technology Letters, Vol. 20, No 20 du 15 octobre 2008 décrit un laser hybride à hétérostructure de type III-V couplé à un guide d'onde en silicium. Le guide d'onde est formé par une saillie en silicium au fond d'une cavité en silicium remplie d'air, la cavité permet de sélectionner une longueur d'onde laser particulière. Le milieu amplificateur du laser hybride, de type guide d'onde actif formé dans une hétérostructure III-V, est couplé optiquement avec le guide d'onde en silicium en partie grâce à une structuration du guide d'onde actif en regard du guide d'onde en silicium.

Le document « Electrically driven hybrid Si/III-V lasers based on adiabatic mode transformers » de B. Ben Bakir et Al. tiré de « PROCEEDING OF SPIE vol. 7719 » du 1er avril 2010 décrit un guide d'onde de type arête couplé à un amplificateur. La réalisation de ce guide d'onde nécessite des précautions particulières lors de sa conception.

**Objet de l'invention**

L'objet de l'invention vise à réaliser une structure laser dont l'efficacité est améliorée par rapport à l'art antérieur et dont le rendement de conception est amélioré.

On tend vers ce but par les revendications annexées et notamment en ce que le créneau est formé par une base et une saillie du guide d'onde, le matériau formant la base étant distinct du matériau formant la saillie.

L'invention concerne aussi un procédé de fabrication d'un laser, comportant les étapes suivantes :

- former le guide d'onde sur un premier substrat et recouvrir au moins partiellement le guide d'onde au niveau du sommet et des flancs du créneau par une première couche en matériau diélectrique,
- former sur un second substrat un empilement de couches destinées à former l'hétérostructure, le sommet de l'empilement étant recouvert d'une seconde couche en matériau diélectrique,
- reporter le premier substrat sur le second substrat, et coller par collage moléculaire la première couche en matériau diélectrique sur la seconde couche en matériau diélectrique,
- retirer le second substrat,
- délimiter l'hétérostructure de type III-V de l'amplificateur.

**Description sommaire des dessins**

D'autres avantages et caractéristiques ressortiront plus clairement de la description qui va suivre de modes particuliers de réalisation de l'invention donnés à titre d'exemples non limitatifs et représentés aux dessins annexés, dans lesquels :

La figure 1 illustre une vue de côté du laser.
La figure 2 illustre une vue de dessus du laser de la figure 1.
La figure 3 illustre une vue en coupe selon A-A du laser de la figure 2.
La figure 4 illustre schématiquement le fonctionnement d'un transformateur de mode.
La figure 5 illustre une réalisation particulière du guide d'onde comportant des transformateurs de mode, la vue étant une vue de dessus du guide d'onde centrée sur la zone du guide d'onde destinée à être en regard de l'amplificateur.
Les figures 6 à 13 illustrent un exemple particulier de procédé de fabrication du laser.
La figure 14 illustre une variante de réalisation du guide d'onde.
La figure 15 illustre un mode de réalisation particulier d'une sortie du laser.

**Description de modes préférentiels de réalisation**

Le laser décrit ci-après diffère de celui de l'art antérieur en ce que le guide d'onde comporte au moins localement au voisinage de l'amplificateur, un créneau dont le sommet et les flancs sont recouverts par un matériau diélectrique, de préférence, à base de $SiO_2$.

Par convention, sur un circuit optique réalisé dans un plan donné, il est défini des états de polarisation TE (pour « transverse electric » en anglais) et TM (pour « transverse magnetic » en anglais) tel que dans l'état TE le champ électrique est parallèle au plan du circuit, alors que le champ magnétique est perpendiculaire au plan du circuit, et dans l'état TM le champ magnétique est parallèle au plan du circuit tandis que le champ électrique est perpendiculaire au plan du circuit. En fait, dans le laser il faudra implicitement considérer un état de polarisation quasi-TE, c'est à dire que le champ électrique est très majoritairement polarisé selon sa direction TE. Ainsi, la structure du laser telle que décrite permettra préférentiellement un couplage du mode TE ou quasi-TE de l'onde.

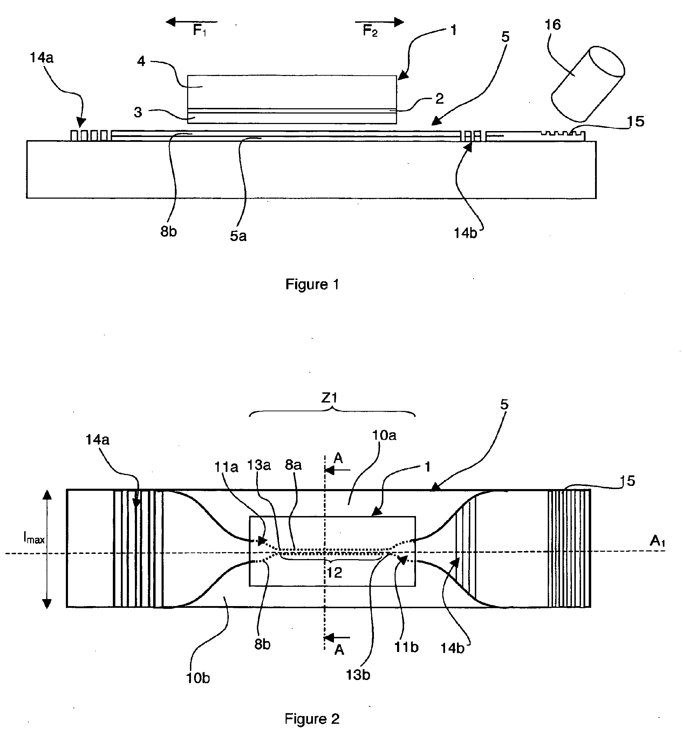

Les figures 1 et 2 illustrent un laser comportant un amplificateur 1 à hétérostructure de type III-V, l'hétérostructure étant agencée pour générer des photons, autrement dit une onde optique. Par hétérostructure de type III-V, on entend l'utilisation de matériaux pouvant être choisis dans la liste non exhaustive suivante : InP, GaAs, InGaAlAs, InGaAsP, AlGaAs, InAsP. L'hétérostructure d'un tel amplificateur 1, aussi appelé milieu à gain, peut comporter un empilement comprenant une couche 2 munie d'éléments quantiques prise en sandwich entre une première couche 3 dopée, de préférence dopée N, et une seconde couche 4 dopée, de préférence dopée P. La première couche 3 dopée lorsqu'elle est dopée N peut comporter un matériau choisi, pour l'essentiel, parmi InP, GaAs, InGaAsP, InGaAlAs, AlGaAs, InAsP. La seconde couche 4 dopée, lorsqu'elle est dopée P, peut comporter un matériau choisi parmi InP, GaAs, InGaAsP, InGaAlAs. Autrement dit, les matériaux utilisés pour la première couche 3 et la seconde couche 4 peuvent être les mêmes, seul le dopage change. Bien entendu, le dopage peut être inversé, c'est-à-dire que la première couche 3 dopée peut être dopée P, et la seconde couche 4 dopée peut être dopée N. La couche 2 d'éléments quantiques peut comporter des puits quantiques ou des boîtes quantiques permettant la recombinaison de trous et d'électrons pour former des photons, et ainsi générer l'onde optique au niveau de l'amplificateur 1. Les éléments quantiques peuvent comporter un matériau tels que InP, GaAs, InGaAsP, InGaAlAs, AlGa, As, InAsP.

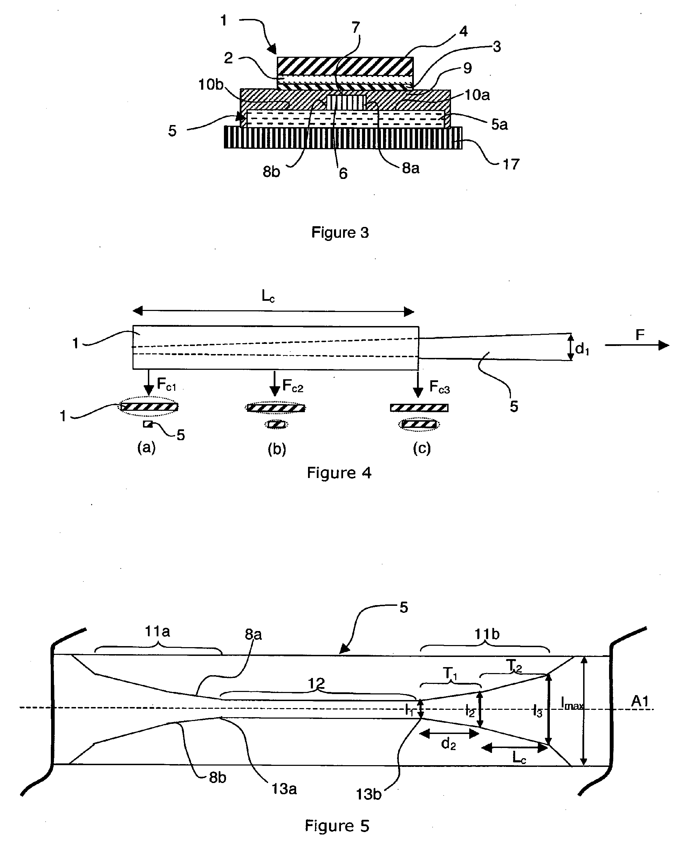

Le laser comporte en outre un guide d'onde 5 couplé optiquement à l'amplificateur 1. Dans l'exemple particulier d'un amplificateur à trois couches 2, 3, 4, tel qu'illustré aux figures 1 et 3 la première couche 3 dopée est proximale du guide d'onde 5.

Sur les figures 1 à 3, le guide d'onde 5 comporte une section, de préférence selon la coupe A-A sensiblement perpendiculaire à l'axe longitudinal A1 du guide d'onde 5, en forme de créneau 6 dont le sommet 7 est proximal de l'amplificateur 1. Autrement dit, le couplage optique entre l'amplificateur 1 et le guide d'onde 5 peut être favorisé au niveau du sommet 7 du créneau 6 par interaction des champs électromagnétiques, c'est-à-dire des modes propres du système. Le sommet 7 du créneau 6 et des flancs latéraux 8a, 8b du créneau 6 sont recouverts par une couche d'un matériau diélectrique 9 (non visible pour des raisons de clarté aux figures 1 et 2) au voisinage de l'amplificateur 1. Par voisinage, on entend qu'au niveau d'une zone Z1 (figure 2) où le guide d'onde 5 et l'amplificateur 1 sont en regard, le sommet 7 du créneau 6 et les flancs latéraux 8a, 8b du créneau 6 sont recouverts par la couche en matériau diélectrique 9. De préférence, sur au moins toute la zone Z1 où le guide d'onde 5 et l'amplificateur 1 sont en regard, le guide d'onde peut avoir une section en créneau et le sommet 7 et les flancs 8a, 8b du créneau 6 sont recouverts par la couche 9 en matériau diélectrique. La distance séparant les deux flancs 8a, 8b du créneau peut varier dans la zone Z1 pour fonctionnaliser ladite zone. Dans l'exemple particulier des figures 1 et 2, l'amplificateur 1 est disposé au-dessus du guide d'onde 5, il y a donc recouvrement partiel de l'un par rapport à l'autre, le sommet 7 du créneau 6 étant proximal de l'amplificateur et séparé dudit amplificateur par au moins un matériau diélectrique 9. De préférence, les axes longitudinaux du guide d'onde 5 et de l'amplificateur 1 sont parallèles.

Le ou les matériaux diélectriques séparant le guide d'onde 5 et l'amplificateur 1 ont, de préférence, un indice de réfraction faible, par exemple compris entre 1,4 (indice proche de la silice) et 2,2 (indice proche de $Si_3N_4$ ou $Al_2O_3$). On parle d'indice de réfraction lorsque l'on considère une onde qui se propage dans un matériau infini en trois dimensions, sa vitesse de propagation est la vitesse de la lumière divisée par l'indice de réfraction.

L'indice de réfraction est à différencier de l'indice effectif. En effet, on parle d'indice effectif lorsque l'on considère une onde se propageant dans une géométrie particulière, par exemple un guide d'onde. Dans une telle géométrie, le champ est altéré ce qui signifie que la vitesse de propagation de l'onde est aussi altérée. La vitesse de propagation est égale à la vitesse de la lumière sur l'indice effectif. Pour calculer l'indice effectif, on utilise la méthode des éléments finis.

Les flancs 8a, 8b du créneau 6 peuvent être définis comme des faces longitudinales, orientées sensiblement selon l'axe longitudinal A1 du guide d'onde 5, et reliant le sommet 7 du créneau 6, au fond 10a, 10b de créneau 6. Autrement dit, au moins localement (au niveau de la zone Z1 où l'amplificateur 1 et le guide d'onde 5 sont en regard) le guide d'onde 5 peut comporter une base 5a sur laquelle est formée une saillie délimitant avec ladite base 5a le créneau 6. La saillie permet notamment de délimiter le sommet 7 et les flancs 8a, 8b. La base 5a et la saillie formant créneau 6 peuvent être formées d'un même matériau ou d'un matériau distinct. Dans le cas d'utilisation de matériaux distincts, cela permet un avantage au niveau de la fabrication, il est alors possible de faire croître la saillie, par exemple en silicium amorphe, destinée à former le créneau 6 sur la base 5a, évitant ainsi une étape de gravure supplémentaire. Le fond 10a, 10b du créneau 6 correspond à une surface de la base 5a à l'interface avec les flancs 8a, 8b, c'est-à-dire la surface de la base 5a située de part et d'autre de la saillie formant créneau 6. L'utilisation d'un tel guide d'onde 5 permet de former un créneau 6 s'interfaçant avec l'amplificateur 1, et dont les dimensions latérales au niveau des flancs 8a, 8b sont inférieures aux dimensions laté-

rales maximales $l_{max}$ du guide d'onde 5. Ceci permet de favoriser un couplage monomode de l'amplificateur 1 avec le guide d'onde 5, notamment lorsque la distance séparant les flancs, au voisinage de l'amplificateur c'est à dire dans la zone Z1 où l'amplificateur 1 et le guide d'onde sont en regard, est comprise entre 500nm et 1100 nm, tout en permettant de coupler le guide d'onde 5 à une fibre optique 16 en élargissant la distance séparant les flancs 8a, 8b du créneau 6 en dehors de la zone Z1 jusqu'à, de préférence, qu'elle devienne égale à $l_{max}$ (la section du guide d'onde devenant alors rectangulaire).

Cette structure de guide d'onde 5 peut aussi être appelée guide arête. Le guide arête au niveau de la zone Z1 peut uniquement comporter la base 5a et la saillie formant créneau 6. Dans le guide arête, l'indice effectif des modes est plus élevé. Il est également plus facile par construction de diminuer le nombre de modes supportés par le guide en diminuant la largeur de l'arête pour favoriser un couplage monomode.

De préférence, le guide d'onde 5 est à base de silicium comme, par exemple, du silicium cristallin, amorphe ou même dopé. Si l'on souhaite fonctionnaliser le guide d'onde 5, le silicium sera dopé pour ajouter une nouvelle fonction optique comme par exemple la variation de l'indice de réfraction par injection de porteurs. De manière générale on peut aussi utiliser des matériaux à moyen indice de réfraction comme par exemple les composés nitrurés tels que le $Si_3N_4$, SiON, ou encore $Al_2O_3$. En fait, le silicium a un indice de réfraction situé autour de 3,5, et la silice un indice de réfraction compris entre 1,4 et 1,5, ainsi par indice moyen de réfraction, on entend un indice de réfraction compris, de préférence, entre 1,8 et 3. Dans le cas où la base 5a et le créneau 6 sont en matériaux distincts, la base 5a peut être en silicium et, de préférence, le créneau 6 est en composé nitruré.

Avantageusement, la base 5a peut être réalisée en silicium cristallin et la saillie formant créneau 6 avec la base 5a peut être réalisée avec un matériau choisi parmi le silicium amorphe, le silicium poly-cristallin, $Si_3N_4$, $SiN_x$, $Al_2O_3$, $TiO_2$. Dans tous les cas selon ce mode de réalisation, les matériaux entre la base 5a et la saillie formant créneau 6 sont distincts. En fait, quand on réalise des circuits photoniques complexes, on associe plusieurs fonctions pour la distribution spatiale et spectrale de la lumière. Ces fonctions sont très dépendantes des paramètres optogéométriques des structures réalisées. Par exemple, une erreur de quelques nanomètres sur l'épaisseur d'un multiplexeur/démultiplexeur en longueur peut décaler la réponse optique (aussi appelée peigne spectral), il peut résulter d'une telle erreur que le système n'est plus apte à répondre aux spécifications de la conception initiale du circuit. Dès lors, les fonctions optiques des composants ne se concatènent plus correctement et le risque d'obtenir un circuit optique global non fonctionnel est important. Lorsque l'on réalise une gravure sur circuit, il y a toujours une incertitude sur l'épaisseur gravée. Il y a également une dispersion de la gravure (donc de l'épaisseur) au niveau de la plaquette.

L'utilisation de deux matériaux distincts permet donc notamment de résoudre la problématique évoquée ci-dessus.

Outre l'avantage indéniable concernant l'utilisation de deux matériaux distincts pour le procédé de fabrication, cette utilisation permet aussi un avantage structurel. En effet, l'utilisation de matériaux distincts induit implicitement que la saillie et la base auront des indices effectifs différents. Autrement dit, il sera possible de favoriser la localisation du mode optique plus ou moins dans la saillie ou dans la base. Cette localisation peut être importante en fonction de l'utilisation du laser. Dans un premier cas considérant une force de couplage identique entre l'amplificateur 1 et le guide d'onde 5, si l'on favorise la présence du mode dans la saillie au détriment de la base 5a l'épaisseur de la couche 9 (de préférence en oxyde) séparant le guide d'onde 5 et l'amplificateur 1 sera plus importante que si l'on favorise la présence du mode optique dans la base. Ceci permet entre autre de choisir un compromis entre efficacité de couplage et réductions des dimensions du laser. Dans un deuxième cas où l'épaisseur de la couche 9 est fixée, il sera possible de choisir les matériaux pour influencer la force de couplage lors de la conception du laser.

Par matériaux distincts, on entend des matériaux distincts par leurs structures ou leurs natures. Ainsi, la sélectivité sera plus faible lorsque l'on utilise deux matériaux différents par leur structure (Si Cristallin, Si poly-cristallin ou Si amorphe).

Un mode correspond à une configuration spatiale du champ électromagnétique tel que défini précédemment (composante TE ou quasi-TE). Typiquement, une onde optique comporte une pluralité de modes. Par monomode, on entend que seul un des modes est couplé optiquement. Lorsque le système est couplé comme dans le cas du laser, on parle de supermodes. Les modes propres, aussi appelés modes locaux, sont ceux du guide d'onde 5 et de l'amplificateur 1 pris individuellement. Les supermodes sont des combinaisons linéaires des modes locaux.

Selon la répartition du champ dans le système couplé, chaque supermode est affecté d'une constante de propagation et donc d'un indice effectif propre. Un indice effectif est le rapport de la vitesse de phase de l'onde optique dans le vide (vitesse de la lumière c) sur la vitesse de phase de l'onde associée au mode optique.

La couche en matériau diélectrique 9 recouvrant le sommet 7 et les flancs 8a, 8b du créneau 6 au voisinage de l'amplificateur 1 peut être réalisée en $SiO_2$. Cette couche en matériau diélectrique 9 améliore l'efficacité du laser en jouant sur les caractéristiques optoélectroniques (notamment les composantes thermiques et optiques) de ce dernier. L'encapsulation du créneau 6, au moins au niveau de son sommet 7 et de ses flancs 8a, 8b, par la couche en matériau diélectrique 9 permet de diminuer les pertes de propagation liées aux rugosités obtenues par exemple lors de la structuration du créneau. En effet, plus les surfaces extérieures du guide d'onde 5 sont rugueuses, plus l'onde se propageant dans le guide d'onde 5, notamment lors du couplage optique entre le guide d'onde 5 et l'amplificateur 1, risque de diffuser hors du guide d'onde 5, limitant ainsi l'efficacité du laser. La couche en matériau diélectrique 9 permet alors, en diminuant le contraste d'indice de réfraction (par exemple le contraste de l'air sur le silicium comme dans l'art antérieur est supérieur au contraste du $SiO_2$ par rapport au silicium) et en comblant les aspérités du guide d'onde 5, de limiter les effets de diffusion. La couche en matériau diélectrique 9 permet aussi d'améliorer l'efficacité du laser car elle joue un rôle de conducteur thermique, permettant de diffuser hors de la zone de gain (zone comportant les puits quantiques) du laser une partie de la chaleur générée par le laser lors de son fonctionnement, contrairement à l'art antérieur où l'air à une conductivité thermique extrêmement faible. Ainsi, on choisira, de préférence, un matériau bon conducteur thermique. La réduction de ces deux effets néfastes au laser permet de manière synergique d'améliorer grandement l'efficacité du laser. Les matériaux tels que $SiO_2$, $Al_2O_3$, $TiO_2$, $SiON$, $HfO_2$, $Si_3N_4$ sont des candidats particulièrement pertinents pour réduire ces effets thermiques et optiques.

Selon un perfectionnement, le fond 10a, 10b du créneau 6 est aussi recouvert par le matériau diélectrique 9 au voisinage de l'amplificateur 1.

Comme illustré à la figure 3, le guide d'onde 5 dans son intégralité, à l'exception d'une face en contact avec un substrat 17 supportant le guide d'onde 5, peut aussi être recouvert par le matériau diélectrique 9 de sorte à diffuser au mieux la chaleur générée par le laser lors de son fonctionnement. Lorsque le guide d'onde 5 est recouvert d'un matériau diélectrique de type $SiO_2$, cela présente aussi un avantage particulier dans le procédé de fabrication. En effet, il est alors possible de former le guide d'onde 5 et l'amplificateur 1, ou les couches destinées à former l'amplificateur 1, sur deux substrats distincts, de recouvrir ces derniers par une couche de $SiO_2$, puis d'utiliser les techniques de collage moléculaires $SiO_2$ vers $SiO_2$ pour mettre en regard le guide d'onde 5 avec l'amplificateur 1 associé. Le collage moléculaire peut aussi très bien fonctionner en utilisant des interfaces $Al_2O_3$ sur $SiO_2$, l'$Al_2O_3$ pouvant alors constituer une fine couche déposée au niveau de l'hétérostructure III-V.

De préférence, que cela soit par une unique couche, ou une couche obtenue par collage moléculaire de deux couches de matériau diélectrique, de préférence identiques, le guide d'onde 5 et l'amplificateur 1 seront séparés par le matériau diélectrique à la fois en contact avec le guide d'onde 5 et avec l'amplificateur 1. La distance de séparation peut être comprise entre 5nm et 500nm. En fait, plus l'espacement est grand, plus la longueur de couplage est grande, tout dépend donc de l'application visée. Un laser long pourra émettre beaucoup de puissance, et un laser court émettra moins de puissance mais sera plus compact et moins consommateur d'énergie.

Selon un développement, la distance séparant les deux flancs 8a, 8b du créneau 6 au voisinage de l'amplificateur 1 est comprise entre 500nm et 1100nm. Une telle distance permet de former un guide d'onde 5 d'indice effectif élevé. Cette distance est alors optimisée pour favoriser le couplage optique monomode par rapport au couplage multimodes au niveau de zones de couplage optique du guide d'onde 5 avec l'amplificateur 1. Une zone de couplage est définie par une zone où le couplage optique est fortement favorisé entre le guide d'onde 5 et l'amplificateur 1. De préférence, le laser comporte deux zones de couplage optique disposées aux extrémités de la zone Z1 où le guide d'onde 5 est en regard de l'amplificateur 1 selon l'axe longitudinal A1. Au niveau des zones de couplage, la distance séparant les deux flancs 8a, 8b du créneau est, de préférence, comprise entre 700nm et 1100nm.

De préférence, chaque zone de couplage a une longueur, selon l'axe longitudinal du guide d'onde qui est un multiple impair de la longueur de couplage $L_c$, et de préférence égale à $L_c$.

L'efficacité de couplage optimal (F) est définie comme étant la fraction de puissance transmise d'un premier guide vers un second guide (ici le guide d'onde 5 vers l'amplificateur 1) au bout d'une distance caractéristique $L_c$ :

$$F = 1 - \left( \frac{\Delta n_{eff,L}}{\Delta n_{eff,S}} \right)^2 \ (1),$$

avec

$$L_c = \frac{\lambda}{2\Delta n_{eff,S}} \ (2),$$

où :

$\lambda$ : est la longueur d'onde d'opération.

$\Delta n_{eff,L}$ : est la différence entre les indices effectifs des modes supportés par les premier et second guides en l'absence de couplage (les guides sont pris individuellement). Ces modes guidés sont appelés modes locaux.

$\Delta n_{eff,S}$ : est la différence entre les indices effectifs des modes supportés par la structure de couplage comprenant les deux guides juxtaposés. Ces deux supermodes sont par construction de symétrie opposée. On parlera alors de supermodes symétrique et antisymétrique. Cette quantité physique est dépendante de la distance Di qui sépare les deux guides. Elle conditionne la longueur de couplage $L_c$ ainsi que le taux de puissance transférée.

À noter que le transfert de puissance d'un guide à l'autre est un processus harmonique et donc réversible. En considérant une puissance nominale $P_0$ injectée dans le premier guide, la puissance collectée ou transmise dans le second guide à la position z s'exprime de la façon suivante :

$$P_{1\to2}(z) = P_0 \cdot F \sin^2\left(\frac{\pi}{2L_c} \cdot z\right) \quad (3)$$

On remarquera d'après la relation (3) que le transfert de puissance du premier guide vers le second guide est optimal pour des multiples impairs de la longueur caractéristique de couplage.

En fonction des dimensions du créneau 6, un seul mode de l'onde, de préférence en composante TE, ou quasi-TE, peut être couplé. De manière générale, on choisira les dimensions du guide d'onde 5 et de l'amplificateur 1 en fonction du mode à coupler.

Selon un développement illustré à la figure 2, le laser peut comprendre un premier transformateur de mode 11 a et un second transformateur de mode 11 b, chacun formé dans le guide d'onde 5 à une extrémité respective de la zone Z1 où l'amplificateur 1 et le guide d'onde 5 sont en regard selon l'axe longitudinal A1 du guide d'onde 5. Un transformateur de mode permet de former au moins une zone de couplage optique comme évoquée ci-dessus, et de transférer progressivement et de manière optimale le mode confiné dans l'amplificateur 1 vers le guide d'onde 5 ou vice versa. Le transformateur de mode 11 a, 11 b permet de s'affranchir des contraintes sur les dimensionnements du guide d'onde 5 et de l'amplificateur 1 pour optimiser le couplage. En effet, afin de coupler de manière la plus efficace possible un guide d'onde 5 avec l'amplificateur 1, il est possible de réaliser ces deux derniers avec des indices effectifs identiques, cependant une telle réalisation implique un alignement et un dimensionnement parfait, ceci étant difficilement réalisable. La forme du guide d'onde 5 peut alors être étudiée de manière à obtenir un couplage robuste par rapport aux variations optogéométriques induites lors de la fabrication. Les transformateurs de mode 11 a, 11 b sont donc présents d'une part pour pallier aux éventuels défauts de conception, et d'autre part pour assurer un couplage optique optimum. Un transformateur de mode peut par exemple être réalisé en faisant varier la distance séparant les deux flancs 8a, 8b du créneau 6 tout en gardant une dimension latérale maximale $l_{max}$ constante au niveau de la base.

En fait, dans le cas d'un couplage direct où la largeur du guide silicium est invariante selon l'axe de propagation, il faut que les indices effectifs soient rigoureusement identiques pour obtenir un couplage de 100%, ce qui pose une contrainte sur la définition de la largeur du créneau, c'est-à-dire de l'arête pour accorder les indices effectifs. La deuxième contrainte est que le couplage optimal ne peut s'effectuer que sur une distance précise qui est la longueur de battement ou longueur de couplage (Lc) évoquée précédemment. Si la longueur est inférieure à Lc, le couplage ne sera pas totalement réalisé. Si la longueur est supérieure à Lc, le couplage se fera sur une distance Lc, puis le mode se découplera en partie sur la distance restante (pour une longueur L=2*Lc, le mode revient à son état initial). Ainsi, on aura tendance à utiliser des multiples impairs de Lc supérieurs à un pour augmenter la probabilité de couplage optique efficace.

Dans le cas d'un couplage adiabatique par transformateur de mode. La largeur du guide d'onde 5 à l'entrée du transformateur de mode 11 a, 11 b est conçue de sorte que l'indice effectif du guide d'onde 5 est inférieur à l'indice effectif de l'amplificateur 1 (qui reste lui invariant selon l'axe de propagation). On applique le raisonnement contraire pour la largeur du guide d'onde 5 à la sortie du transformateur de mode 11 a, 11 b. Ainsi, tout au long du transformateur de mode, l'indice effectif sera inférieur, égal et puis supérieur à l'indice effectif de l'amplificateur, et on peut par ce biais coupler de manière progressive la puissance optique (et ce de manière réversible guide vers amplificateur, ou amplificateur vers guide).

Un autre avantage des transformateurs de mode est que le couplage est efficace à partir d'une certaine longueur, et il reste sensiblement identique selon les conceptions au-delà de cette longueur. En effet, sans l'utilisation des transformateurs de mode, on aurait tendance à avoir un recouvrement guide d'onde/amplificateur très long au niveau des zones de couplage pour augmenter les probabilités de couplage efficace. Les transformateurs de mode 11a, 11 b permettent de s'affranchir de cette problématique en utilisant par exemple une longueur égale à Lc pour la zone de couplage optique.

Ce principe est illustré à la figure 4, en partant de la gauche vers la droite de la figure 4, le guide d'onde 5 à section variable a une forme divergente selon F correspondant à une variation de sa dimension latérale $d_1$. L'amplificateur 1 disposé au-dessus du guide d'onde 5 est à section constante. Une onde est représentée par des pointillés au niveau des coupes (a), (b), (c), perpendiculairement au sens de déplacement F de ladite onde, lesdites coupes étant respectivement indiquées par les flèches $F_{c1}$, $F_{c2}$, $F_{c3}$. L'onde est d'abord confinée dans l'amplificateur 1 (a), puis au fur et à mesure que la section du guide d'onde 5 s'élargie (selon $d_1$), les indices effectifs se rapprochent et l'onde est petit à petit couplée au guide d'onde 5 (b) jusqu'à être couplée totalement (c) sur la longueur de couplage Lc (au début l'indice effectif du guide est inférieur à l'indice effectif de l'amplificateur, puis on a un accord de phase avec l'indice effectif du guide égal à l'indice effectif de l'amplificateur, puis l'indice effectif du guide devient supérieur à l'indice effectif de l'amplificateur). La structuration adaptée du guide d'onde 5 permet au laser, par transformation modale, de bénéficier à plein du gain disponible. Ceci est possible car dans une partie centrale du laser (partie entre les deux transformateurs de mode) le champ électromagnétique (c'est-à-dire le mode) est principalement confiné dans la zone active (milieu amplificateur) et le recouvrement avec les puits quantiques est maximal, permettant ainsi de renforcer le gain modal et de réduire le seuil du laser par rapport à l'art antérieur. Cette transformation modale est alors adiabatique, et elle garantit aux extrémités du laser un couplage optimal vers un circuit photonique sous-jacent.

De préférence, comme illustré à la figure 5 chaque transformateur de mode 11 a, 11 b peut comporter un premier tronçon $T_1$ agencé de sorte à limiter les pertes engendrées par les processus de diffraction lors d'un couplage amplificateur 1 vers guide d'onde 5, le processus étant réversible, il se passe la même chose lors du couplage guide d'onde 5 vers amplificateur. Ce premier tronçon $T_1$ peut être divergent (vers la droite de la figure), et sur ce tronçon $T_1$, la distance séparant les deux flancs 8a, 8b du créneau évolue entre $l_1$ et $l_2$ avec, de préférence $l_1$=500nm et $l_2$=700nm, sur une longueur $d_2$ de quelques microns (typiquement une dizaine, et de préférence compris entre 2μm et 20μm). Ensuite, le transformateur de mode 11 a, 11 b peut comporter un deuxième tronçon $T_2$ dit de collection optimisée situé à la suite du premier tronçon $T_1$ selon son sens de divergence. Ce deuxième tronçon $T_2$ a, de préférence, une longueur sensiblement égale à la longueur de couplage Lc nécessaire pour coupler totalement l'onde de l'amplificateur 1 au guide d'onde 5 ou vice versa. Le deuxième tronçon $T_2$ est, de préférence, aussi divergent dans le même sens que le premier tronçon $T_1$. Sur ce deuxième tronçon $T_2$ la plus petite dimension $l_2$ séparant les deux flancs 8a, 8b du créneau 6 peut être de 700nm alors que la plus grande dimension $l_3$ séparant les deux flancs 8a, 8b du créneau peut être de 1100nm. A la suite du deuxième tronçon $T_2$, la distance séparant les deux flancs 8a, 8b du créneau 6 peut augmenter jusqu'à devenir égale à la dimension latérale maximale $l_{max}$ du guide d'onde 5, c'est-à-dire jusqu'à la disparition du créneau 6 pour former un guide d'onde 1 à section de forme générale rectangulaire. Selon une variante non représentée $l_{max}$ peut être égale à $l_3$. Au niveau du guide d'onde 5, les premiers tronçons $T_1$ des deux transformateurs de mode 11 a, 11 b sont proximaux et divergent dans deux sens opposés sensiblement parallèles à l'axe longitudinal A1. Les transformateurs de mode 11 a, 11 b sont, de préférence, séparés par une portion 12 de créneau, de préférence de section constante, au niveau de laquelle la distance séparant les deux flancs 8a, 8b du créneau est inférieure ou égale à $l_1$.

Ainsi, selon un développement, chacun des premier et second transformateurs de mode 11 a, 11 b forme un goulot d'étranglement 13a, 13b défini par les flancs 8a, 8b du créneau 6. Les deux goulots 13a, 13b peuvent alors être orientés l'un vers l'autre de sorte à délimiter entre ces deux derniers la portion 12, interdisant, ou limitant très fortement, tout couplage optique entre le guide d'onde 5 et l'amplificateur 1 de sorte à confiner l'onde dans l'amplificateur 1 au voisinage de la portion 12 de créneau 6.

Sur les figures 2 et 5, entre les deux transformateur de mode 11 a, 11 b, le guide d'onde 5, et plus particulièrement la distance séparant les flancs 8a, 8b du créneau 6, est dimensionnée pour éviter, ou limiter très fortement, un couplage optique entre l'amplificateur 1 et le guide d'onde 5. Ainsi, l'onde est confinée dans l'amplificateur pour y être amplifiée. Autrement dit, on choisira entre les deux transformateurs de mode 11 a, 11 b une dimension du créneau qui sera située de manière à ce que l'indice effectif du guide soit inférieur à l'indice effectif de l'amplificateur. À titre d'exemple, le dimensionnement évitant, ou limitant, le couplage optique peut être réalisé par un rétrécissement de la distance séparant les flancs 8a, 8b du créneau 6 sur une portion 12 du créneau 6 orientée selon l'axe longitudinal A1, typiquement cette distance est inférieure ou égale à 500nm.

Dans un laser tel que décrit, l'onde générée dans l'amplificateur 1 peut se propager à la fois selon des directions opposées et sensiblement parallèles à l'axe longitudinal A1 du guide d'onde 5, lesdites directions étant indiquées par les flèches $F_1$ et $F_2$ à la figure 1. Ainsi, selon la flèche $F_1$ l'onde peut passer de l'amplificateur 1 au guide d'onde 5, par exemple au niveau du premier transformateur de mode 11a, puis atteindre un premier réflecteur 14a l'orientant selon la direction $F_2$, l'onde est alors recouplée à l'amplificateur 1, le cas échéant au niveau du premier transformateur de mode 11a (figure 2), traverse l'amplificateur puis est couplée au guide d'onde 5, de préférence au niveau du second transformateur de mode 11 b, l'onde peut alors rencontrer un second réflecteur 14b la renvoyant dans le sens selon la flèche F1 de sorte à repasser dans l'amplificateur 1, etc. Les premier et second réflecteurs 14a, 14b forment alors une cavité du laser permettant à l'onde de repasser plusieurs fois dans l'amplificateur 1 pour y être amplifiée. L'un des réflecteurs est, de préférence, un élément réfléchissant, et l'autre est un élément semi-réfléchissant pour laisser sortir une onde laser une fois que sa puissance est suffisante. Dans l'exemple particulier des figures 1 et 2, le premier réflecteur 14a est réfléchissant, et le second réflecteur 14b est semi-réfléchissant.

La cavité laser comporte, de préférence, deux miroirs de Bragg. Chacun de ces miroirs a une réflectivité différente. Ainsi, le premier réflecteur 14a peut être un miroir de Bragg dont la réflectivité est supérieure à 90% et le second réflecteur 14b peut aussi être un miroir de Bragg, mais dont la réflectivité est de l'ordre de 50%. Cette asymétrie permet de transférer le mode laser dans un sens privilégié, par exemple vers un réseau 15 de sortie couplé à une fibre 16 en sortie du second réflecteur 14b, la sortie du second réflecteur 14b étant opposée à l'amplificateur 1.

Pour résumer, le guide d'onde 5 peut être vu comme un élément longitudinal orienté selon l'axe A1 aux figures 1 et 2, et pouvant comporter plusieurs zones successives ayant différentes fonctionnalités. Sur la figure 2, en partant de la gauche vers la droite on retrouve alors une zone réfléchissante définie par le premier réflecteur 14a, puis, si ce n'est pas encore le cas, une zone où la section du guide d'onde 5 est conformée en créneau 6 pour retrouver une zone semi-réfléchissante définie par le second réflecteur 14b. La zone semi-réfléchissante peut être suivie d'un réseau 15 dit de sortie permettant par exemple le couplage du laser avec une fibre optique 16. En fonction de la structure, du laser, le premier réflecteur 14a et le second réflecteur 14b sont formés dans le guide d'onde 5, de part et d'autre de l'amplificateur 1 dans une zone où le guide d'onde 5 est de section rectangulaire ou de section à créneau. Entre ces deux réflecteurs 14a, 14b, on retrouve la zone Z1.

Le laser peut en outre comporter un modulateur agencé pour coder une information à une sortie du laser. Ce modulateur peut être disposé, par exemple dans le guide d'onde 5, entre le second réflecteur semi-réfléchissant 14b et le réseau 15 de sortie. Un tel modulateur peut par exemple être de type électro-absorption ou de Mach Zehnder. Le modulateur peut comporter des matériaux de type III-V et/ou de silicium.

Pour former le guide d'onde 5, il peut être choisi un guide d'onde, par exemple en silicium, formant un ruban de section, perpendiculairement à l'axe A1, rectangulaire, et dont la hauteur maximale est, de préférence, de 500nm et dont la largeur est, de préférence de 10μm, ce ruban peut être structuré afin de former les différentes zones et notamment le créneau 6.

Dans l'exemple de réalisation où le guide d'onde 5 est formé dans des matériaux distincts, seule la couche supérieure proximale à l'amplificateur sera structurée pour former le créneau et les matériaux seront structurés pour former les premier et second réflecteurs.

Les zones réfléchissante et semi-réfléchissante, formées par les premier et second réflecteurs 14a, 14b peuvent être obtenues par gravure du guide d'onde, perpendiculairement à l'axe longitudinal A1 sur toute sa hauteur de 500nm et sa largeur de 10μm. Autrement dit, le guide d'onde 5 est ponctuellement interrompu de sorte à créer des zones plus ou moins réflectives. Ceci peut être réalisé par des gravures formant des tranchées sur toute la hauteur et la largeur du guide d'onde 5, lesdites tranchées étant d'axe sensiblement perpendiculaire à l'axe longitudinal A1 du guide d'onde 5. À la place des tranchées, il est possible de former des réseaux périodiques en deux dimensions de trous comme les cristaux photoniques. En fait, au lieu d'avoir des lignes de tranchées parallèles, on peut avoir une matrice de trous, cette configuration peut améliorer le pouvoir réfléchissant des réflecteurs.

Le réseau 15 de couplage avec la fibre optique 16 peut comporter un réseau de tranchées réalisées partiellement dans le guide d'onde 5, par exemple par gravure de ce dernier. De préférence, les tranchées sont sensiblement perpendiculaires à l'axe longitudinal A1 du guide d'onde 5, et sont formées sur une face supérieure du guide d'onde 5, la face supérieure étant sur la figure 1 la face du guide d'onde 5 orientée vers le haut et sensiblement parallèle au plan du guide d'onde 5, ou comme sur la figure 2, la face du guide d'onde 5 dans le plan de la feuille. Pour un guide d'onde 5 selon les dimensions précitées, les tranchées peuvent avoir une profondeur de 125nm. Le réseau peut, par exemple, être défini en utilisant un masque dur, puis une gravure directionnelle.

Entre les zones réfléchissante et semi-réfléchissante le guide d'onde comporte une section conformée en créneau pouvant être obtenue en utilisant un masque dur structurant le guide d'onde 5 (qu'il soit réalisé en un ou deux matériaux distincts comme évoqué ci-dessus). La hauteur du créneau 6, et donc des flancs 8a, 8b, est, de préférence de, 250nm. Autrement dit, dans la zone correspondante, la base 5a du guide d'onde 5 est d'épaisseur sensiblement égale à 250nm, et sur cette base 5a s'étend la saillie longitudinale formant avec la base 5a le créneau 6. La distance séparant les deux flancs 8a, 8b latéraux du créneau peut, comme évoqué ci-dessus, avoir une dimension variable le long de l'axe longitudinal A1 du guide d'onde 5 de sorte à délimiter les transformateurs de mode 11 a, 11 b et, entre les transformateurs de mode 11 a, 11 b, délimiter la portion 12 du guide d'onde 5 où le couplage optique entre le guide d'onde 5 et l'amplificateur 1 n'est pas possible, ou très fortement défavorisé. Ainsi, toujours en partant de la gauche vers la droite sur la figure 2, la zone à créneau peut comporter un premier rétrécissement de la distance séparant les flancs 8a, 8b de sorte à former un premier transformateur de mode 11 a, puis un second rétrécissement (formant le goulot 13a) agencé de sorte à éviter tout couplage optique entre le guide d'onde 5 et l'amplificateur 1 au niveau dudit second rétrécissement. À la suite du second rétrécissement et après la portion 12, la distance séparant les deux flancs peut être élargie de sorte à former le second transformateur de mode 11 b. De préférence, entre un transformateur de mode 11 a, 11 b et le réflecteur 14a, 14b situé à proximité dudit transformateur de mode 11 a, 11 b, la distance séparant les deux flancs 8a, 8b reprend progressivement une valeur se rapprochant de, voire égalant, la dimension latérale maximale $l_{max}$ du guide d'onde.

Les différents dimensionnements du guide d'onde 5 et de l'amplificateur 1 peuvent être obtenus par des méthodes de simulation utilisant, par exemple, la suite logicielle RSOFT©. Par exemple, pour calculer les modes propres et les constantes de propagation, ou de manière équivalentes les indices effectifs associés, il pourra être utilisé la méthode des éléments finis du module FEMSIM de RSOFT©. L'efficacité du couplage peut être calculée en utilisant la méthode de propagation des faisceaux (BPM pour « Beam Propagation Method » en anglais) telle que définie dans le module BeamProp de RSOFT©. Pour calculer les éléments nanostructurés comme la réflectivité des premier et second réflecteurs 14a, 14b, les tranchées du réseau 15 pour le couplage à une fibre optique 16, il peut être utilisé la méthode temporelle des différences finies FDTD (pour « Finite-Difference Time-Domain Method » en anglais) du module Fullwave de RSOFT©. Le logiciel PHOTODESIGN peut aussi être utilisé pour caractériser le laser. Bien que la structure ait beaucoup d'influence sur la longueur de couplage, avantageusement Lc est comprise entre 25$\mu$m et 500$\mu$m. Grâce à ces suites logicielles, les calculs électromagnétiques (indices effectifs, calculs et longueurs de couplage, cartographie des champs, etc.) du laser peuvent être obtenus facilement.

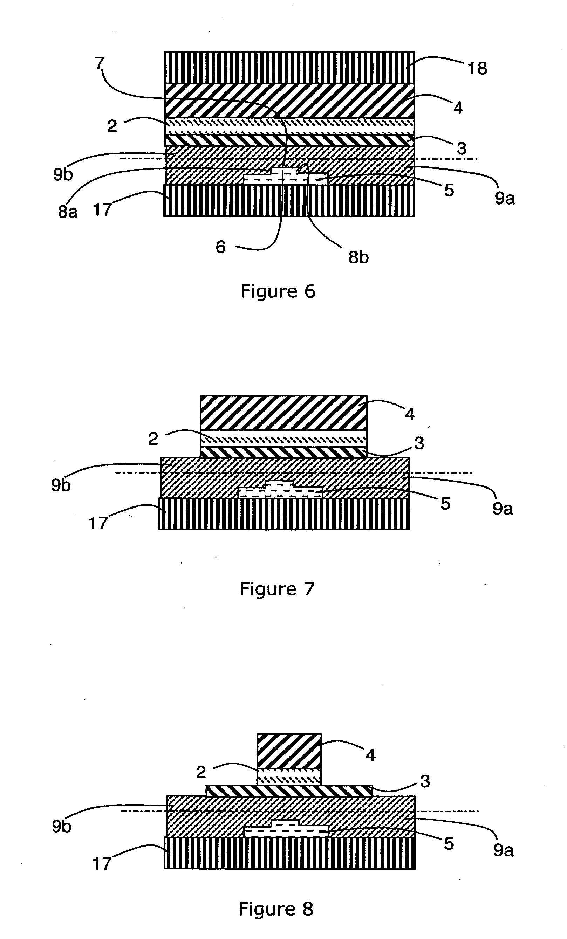

Afin de réaliser la structure du laser tel que décrit ci-dessus, il peut être utilisé un substrat de type SOI (Silicium On Insulator). Le guide d'onde peut alors être formé dans une membrane silicium de 500nm. Cette membrane de silicium peut reposer sur une couche d'oxyde thermique reposant sur du silicium de plusieurs centaines de microns d'épaisseur. Dans une étape du procédé de fabrication (figure 6), le guide d'onde 5 peut être formé sur un premier substrat 17 et, par exemple, être structuré tel que décrit précédemment. Le guide d'onde 5 est alors recouvert au moins partiellement (au niveau des flancs 8a, 8b et du sommet 7 de créneau 6 au voisinage du futur amplificateur), et de préférence totalement, par une première couche en matériau diélectrique 9a, typiquement du SiO$_2$, Al$_2$O$_3$ ou Si$_3$N$_4$. Lors de sa formation, le guide d'onde 5 comporte avantageusement une base et une saillie en matériaux distincts tels que décrits ci-avant. Comme indiqué, l'utilisation de matériaux distincts permet une fabrication plus aisée du laser, notamment en utilisant la sélectivité des matériaux. Par exemple, on peut dans un premier temps fabriquer les fonctions passives dans un SOI monocristallin en formant un ou des guides ruban dans le substrat SOI de sorte à former la base évoquée précédemment, par exemple d'épaisseur de 250nm. Une fois la base réalisée, du Si polycristallin peut être déposé puis, par exemple suite à une étape de lithographie et de gravure, la saillie est formée pour par exemple former le créneau et avantageusement les transformateurs de modes.

Sur un second substrat 18, un empilement de couches destinées à former l'hétérostructure de type III-V de l'amplificateur peut être réalisé en déposant par exemple successivement sur ledit second substrat 18 la seconde couche 4 dopée, la couche 2 munie d'éléments quantiques, la première couche 3 dopée, la seconde couche 4 dopée étant proximale au second substrat 18. Une deuxième couche en matériau diélectrique 9b recouvre le sommet de l'empilement opposé au second substrat 18. La deuxième couche 9b en matériau diélectrique est compatible pour un collage moléculaire avec la première couche en matériau diélectrique 9a du premier substrat 17, typiquement du SiO$_2$, pour permettre un collage moléculaire SiO$_2$ sur SiO$_2$.

Ensuite, de préférence après mise à plat des couches en matériau diélectrique 9a, 9b des deux substrats 17, 18, le premier substrat 17 peut être reporté sur le second substrat 18 (figure 6) de sorte à mettre la première couche diélectrique 9a en contact avec la deuxième couche diélectrique 9b, pour les coller, par exemple par collage moléculaire en disposant l'empilement au-dessus du guide d'onde 5. Sur les figures 6 à 8, la ligne en pointillés représente fictivement la limite du collage moléculaire après réalisation du collage. Après collage moléculaire, on peut considérer qu'une seule couche de matériau diélectrique sépare le guide d'onde 5 de l'amplificateur 1.

Après collage moléculaire, le second substrat 18 est retiré, puis l'empilement est structuré de sorte à délimiter, au moins de forme générale, l'hétérostructure de type III-V de l'amplificateur 1 (figure 7). Pour cela, la seconde couche 4 dopée, la couche 2 d'éléments quantiques et la première couche 3 dopée sont gravées jusqu'à la deuxième couche 9b en matériau diélectrique (qui peut former après collage moléculaire avec la première couche en matériau diélectrique 9a une unique couche en matériau diélectrique). Ces gravures peuvent être réalisées par voie humide via des gravures chimiques à forte sélectivité permettant d'arrêter la gravure sur une couche précise tout en ayant une vitesse élevée de gravure, typiquement 10$\mu$m/min contre 100nm/min pour une gravure sèche RIE (gravure ionique réactive). Lorsque le premier substrat 17 comporte une pluralité de guides d'onde, on délimitera une hétérostructure distincte au-dessus de chaque guide d'onde 5 selon le même procédé. Selon un exemple particulier, la seconde couche 4 dopée est en InP, et sera gravée par HCl à 37% pur ou dilué avec H$_2$O, la couche 2 munie d'éléments quantique est en InGaAsP, et sera gravée par H$_2$SO$_4$/H$_2$O$_2$/H$_2$O (en proportion 1/1/10), et la première couche dopée 3 est en InP, et sera gravée par HCl à 37% pur ou dilué avec H$_2$O.

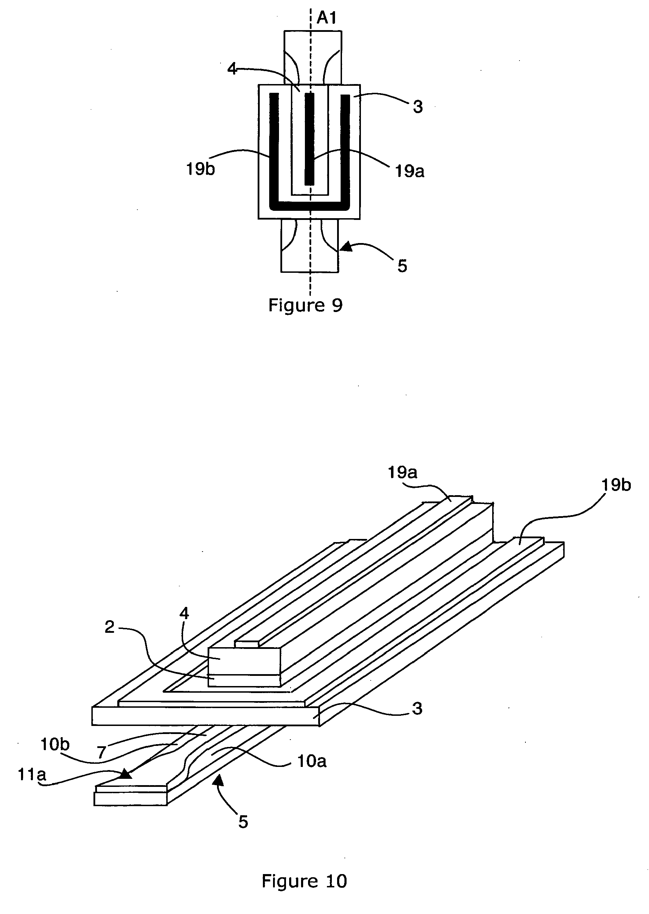

Ensuite, l'hétérostructure de type III-V peut être partiellement gravée (seconde couche 4 dopée et couche 2 d'éléments quantiques) jusqu'à la première couche 3 dopée (figure 8) de sorte à rendre la première couche 3 dopée accessible pour y former un contact électrique. De préférence, après gravure, les zones accessibles de la première couche 3 dopée, vues de dessus, ont la forme d'un U (figure 9) délimité au niveau des bords de l'hétérostructure, les barres du U, ayant une extrémité libre, sont sensiblement parallèles à l'axe longitudinal A1 du guide d'onde 5. La gravure partielle de l'hétérostructure de type III-V constitue une étape de fabrication difficile. Cette étape de gravure peut être réalisée en utilisant, de préférence, un masque dur déposé au sommet de l'hétérostructure, et structuré de manière idoine pour former un U par lithographie de la résine du masque. Typiquement, il est possible d'obtenir une forme rectangulaire d'environ 5$\mu$m de large et 1000$\mu$m de long, dont la longueur est orientée selon l'axe longitudinal du guide d'onde 5 après développement de la résine. Le masque dur peut être réalisé par dépôt d'un nitrure sur 900nm par PECVD suivi du dépôt d'une résine positive et d'une lithographie suivie d'une gravure du masque par plasma SF6. La gravure de l'empilement peut ensuite se décomposer en deux temps. Dans un premier temps, selon le masque dur, la seconde couche 4 dopée est gravée par plasma $CH_4/H_2$ avec arrêt à la couche 2 d'éléments quantiques, puis cette dernière est gravée, de préférence par chimie $H_2SO_4/H_2O_2/H_2O$ (en proportion 1/1/10) jusqu'à la première couche 3 dopée. Les solutions chimiques utilisées comportent une grande sélectivité par rapport à la première couche 3 dopée de sorte à s'arrêter à cette dernière sans la graver. Les deux étapes de gravure peuvent être vérifiées par contrôle de la profondeur de gravure, par exemple par profilométrie et test électrique. Le cas échéant, après ce contrôle, le masque dur est retiré. Dans le cas où le masque dur est à base de SiNx, ce dernier peut être retiré par plasma SF6.

Comme illustré aux figures 9 et 10, des premier et second contacts 19a, 19b électriques sont ensuite formés au niveau de l'hétérostructure. Le premier contact 19a est formé au sommet de l'empilement sur la seconde couche 4 dopée, et le second contact 19b est formé sur la première couche 3 dopée et forme, de préférence, un U entourant partiellement la couche 2 d'éléments quantiques. Ces contacts 19a, 19b peuvent être réalisés en utilisant un masque, un dépôt de métal et un procédé à décollement (« lift off » en anglais). Les contacts peuvent permettre au dispositif final de générer les photons et donc l'onde optique.

Afin d'améliorer le contact électrique avec les première et seconde couches 3, 4 dopées, les premier et second contacts 19a, 19b peuvent être recuits par exemple par recuit rapide à 400°C par rapide, on entend un temps de recuit de préférence compris entre 30 secondes et 150 secondes. L'avantage de ce recuit est la réduction significative de la résistance électrique de contact au niveau desdits premier et second contacts 19a, 19b.

En faisant abstraction des couches, ou de la couche, en matériaux diélectriques séparant le guide d'onde 5 de l'amplificateur 1, après formation des contacts, le laser est illustré en trois dimensions à la figure 10. Cette figure 10 illustre le guide d'onde 5 couplé optiquement avec l'amplificateur, le transformateur de mode 11a est en regard de l'amplificateur au niveau de son extrémité longitudinale. On repère clairement les contacts 19a, 19b respectivement en contact électrique avec la seconde couche 4 dopée et la première couche 3 dopée.

Dans le cas où plusieurs lasers sont réalisés et reliés sur un même premier substrat 17, les liaisons électriques sont supprimées entre chaque dispositif pour les rendre électriquement indépendants.

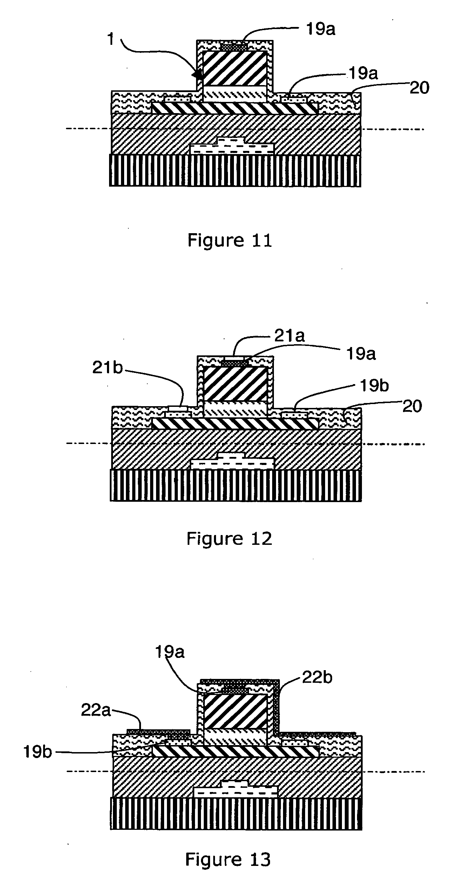

Le laser peut fonctionner en injectant du courant au niveau des contacts 19a, 19b. Cependant, la reprise de ces contacts électriques n'est pas une chose aisée car il ne sont pas situés dans un même plan. Ainsi, une étape supplémentaire peut consister à former des éléments de reprise de contact dans un même plan. Pour cela, une couche de passivation 20 électriquement isolante peut être déposée de manière conforme sur le laser (figure 11) de sorte à recouvrir au moins l'hétérostructure (amplificateur 1). La couche de passivation 20 forme alors un créneau. Cette couche de passivation 20 est ensuite ouverte (figure 12) d'une part au niveau du premier contact 19a pour former une première ouverture 21 a laissant accessible ledit premier contact 19a, et d'autre part au niveau du second contact 19b pour former une seconde ouverture 21 b laissant accessible une partie du second contact 19b. Ces ouvertures 21 a, 21 b ont pour but de former un élargissement des contacts en déposant par la suite une couche de métal. La seconde ouverture 21 b est, de préférence, formée qu'au-dessus d'une branche du U formant le second contact 19b.

Sur la figure 13, le dépôt sélectif, ou dépôt suivi d'une gravure, d'une couche de métal permet de former sur la couche de passivation 20, à la gauche de la couche 2 d'éléments quantiques sur la figure 13, un premier élément de reprise de contact 22a, en contact électrique avec le second contact 19b. Un second élément de reprise de contact 22b, en contact électrique avec le premier contact 19a, recouvre au moins en partie le sommet du créneau formé par la couche de passivation 20 au-dessus du premier contact 19a, le bord du créneau de la couche de passivation 20 rejoignant le fond de créneau de la couche de passivation (à droite de la couche 2 sur la figure 13) et le fond de créneau de la couche de passivation 20 à droite de la couche 2 d'éléments quantiques sur la figure 13. Dès lors, le premier élément de reprise de contact 22a recouvrant le fond de créneau à gauche de la couche 2 d'éléments quantiques est formé dans le même plan qu'une zone du second élément de reprise de contact 22b recouvrant le fond de créneau de la couche de passivation 20 à droite de la couche 2 d'éléments quantiques sur la figure 13. Les premier et second éléments de reprise de contact sont électriquement indépendants.

Grâce à cette structure, les contacts peuvent être repris dans un même plan.

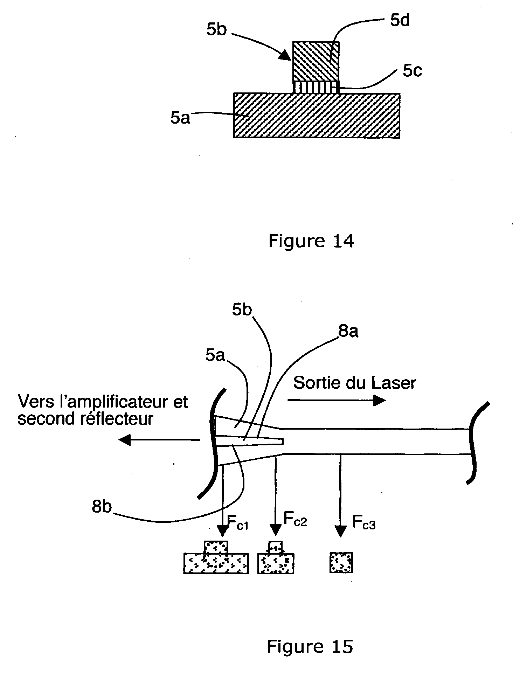

Selon un mode de réalisation particulier illustré à la figure 14, l'élément formant saillie 5b de la base 5a et délimitant, avec ladite base 5a, le créneau se présente sous la forme d'un bi-couche délimitant un empilement. Dans ce bi-couche une première couche 5c, avantageusement en contact direct avec la base 5a, est réalisée en matériau électriquement isolant (diélectrique) comme de l'oxyde ou du SiNx. L'autre couche 5d est formée dans un matériau choisi parmi le silicium amorphe, le silicium poly-cristallin, $Si_3N_4$, $SiN_x$, $Al_2O_3$, $TiO_2$. Cette première couche 5c présente deux avantages, le premier est qu'elle permet en fonction de son épaisseur de favoriser la distribution du mode de l'onde optique comme évoqué précédemment, l'autre avantage réside dans le procédé de fabrication du laser. En effet, il existe une grande sélectivité entre le Si et les oxydes en général, typiquement cette sélectivité peut être supérieure à 40 entre le Si et le $SiO_2$. Il est ainsi plus simple de définir un créneau par la technique gravure par ion réactifs (RIE pour Reactive-Ion Etching) grâce à l'obtention d'un signal d'arrêt de gravure issu de la détection du matériau formant la première couche 5c. Cette détection peut être réalisée par un équipement de mesure qui précise alors la détection de fin d'attaque du matériau concerné. Autrement dit, dans le procédé visé ci-avant, le premier substrat 17 peut comporter un empilement successif d'une couche destinée à former la base 5a du guide d'onde 5, d'une couche électriquement isolante destinée à former la première couche 5c de l'élément en saillie, et une couche destinée à former la seconde couche 5d de l'élément en saillie 5b. Cet empilement de trois couches peut alors être structuré de manière simple et optimale en utilisant les propriétés de sélectivité des différents matériaux, tout en évitant d'attaquer la base 5a en fin de structuration de l'élément en saillie 5b. Pour les problèmes de sélectivité, la première couche et la seconde couche 5c, 5d sont avantageusement en matériaux différents.

Selon une variante applicable aux différents modes de réalisation et illustrée à la figure 15, la sortie du laser peut être configurée de manière spéciale, avantageusement en aval des second réflecteurs, afin d'éviter les pertes entre la saillie 5b et la base 5a. Autrement dit, il est possible de prévoir une transition adiabatique et un confinement progressif du mode optique vers la base 5a uniquement en diminuant la distance de séparation des flancs 8a, 8b latéraux de l'élément en saillie 5b jusqu'à interruption de la saillie dans une direction opposée à l'amplificateur. Sur cette figure 15, les flèches Fc1, Fc2, Fc3 représentent des coupes du guide d'onde dans lesquelles les ronds en pointillés représentent le mode de l'onde optique. On voit clairement que selon la direction de sortie du laser, le mode optique est petit à petit confiné dans la base jusqu'à interruption de l'élément en saillie 5a. Avantageusement, la base 5a a aussi des dimensions latérales qui diminuent dans la direction de la sortie pour réduire l'encombrement et former un guide d'onde passif en direction d'un composant actif.

**Revendications**

1. Laser comportant :

- un amplificateur (1) à hétérostructure de type III-V, agencée pour générer des photons,
- un guide d'onde (5), couplé optiquement à l'amplificateur (1), et comportant une section en forme de créneau (6) dont le sommet (7) est proximal de l'amplificateur (1), le sommet (7) du créneau (6) et les flancs (8a, 8b) latéraux du créneau (6) étant recouverts par une couche (9) d'un matériau diélectrique au voisinage de l'amplificateur (1),

**caractérisé en ce que** le créneau est formé par une base (5a) et une saillie du guide d'onde (5), le matériau formant la base (5a) étant distinct du matériau formant la saillie (5b).

2. Laser selon la revendication 1, **caractérisé en ce que** le fond (10a, 10b) du créneau (6) est recouvert par le matériau diélectrique au voisinage de l'amplificateur (1).

3. Laser selon l'une des revendications 1 et 2, **caractérisé en ce que** le matériau diélectrique est du $SiO_2$.

4. Laser selon l'une quelconque des revendications 1 à 3, **caractérisé en ce que** la distance séparant les deux flancs du créneau (6) au voisinage de l'amplificateur (1) est comprise entre 500nm et 1100nm.

5. Laser selon l'une quelconque des revendications 1 à 4, **caractérisé en ce qu'**il comprend un premier transformateur de mode (11a) et un second transformateur de mode (11 b), chacun formé dans le guide d'onde (5) à une extrémité respective d'une zone (Z1) où l'amplificateur (1) et le guide d'onde (5) sont en regard selon un axe longitudinal (A1) du guide d'onde (5).

6. Laser selon la revendication 5, **caractérisé en ce que** chacun des premier et second transformateurs de mode (11 a, 11b) forme un goulot (13a, 13b) d'étranglement défini par les flancs (8a, 8b) du créneau (6).

7. Laser selon l'une quelconque des revendications précédentes **caractérisé en ce qu'**il comporte un modulateur apte à coder une information à une sortie du laser.

8. Laser selon l'une quelconque des revendications précédentes **caractérisé en ce qu'**au niveau d'une sortie du laser, la distance séparant les flancs latéraux (8a, 8b) va en diminuant jusqu'à interruption de la saillie dans une direction opposée à l'amplificateur (1) pour réaliser une transition adiabatique et un confinement progressif d'un mode optique vers la base (5a) uniquement.

9. Laser selon l'une quelconque des revendications précédentes, **caractérisé en ce que** la saillie (5b) est formée par un empilement d'une première couche (5c) en diélectrique en contact direct avec la base (5a) et d'une seconde couche (5d) d'un matériau choisi parmi le silicium amorphe, le silicium polycristallin, $Si_3N_4$, $SiN_x$, $Al_2O_3$, $TiO_2$.

10. Procédé de fabrication d'un laser selon la revendication 1, **caractérisé en ce qu'**il comporte les étapes suivantes :

- former le guide d'onde (5) sur un premier substrat (17) et recouvrir au moins partiellement le guide d'onde (5) au niveau du sommet (7) et des flancs (8a 8b) du créneau (6) par une première couche en matériau diélectrique (9a),
- former sur un second substrat (18) un empilement de couches destinées à former l'hétérostructure de type III-V, le sommet de l'empilement étant recouvert d'une seconde couche en matériau diélectrique (9b),
- reporter le premier substrat (17) sur le second substrat (18), et coller par collage moléculaire la première couche en matériau diélectrique (9a) sur la seconde couche en matériau diélectrique (9b),
- retirer le second substrat (18),
- délimiter l'hétérostructure de type III-V de l'amplificateur (1).

11. Procédé de fabrication selon la revendication 10, **caractérisé en ce que** l'étape de collage moléculaire est une étape de collage SiO$_2$ sur SiO$_2$.


**Patentansprüche**

1. Laser, umfassend:

- einen Verstärker (1) mit Heterostruktur vom Typ III-V, der dazu eingerichtet ist, Photonen zu erzeugen,
- einen Wellenleiter (5), der mit dem Verstärker (1) optisch gekoppelt ist und der einen Abschnitt mit der Form einer Zinne (6) umfasst, deren Scheitel (7) zu dem Verstärker (1) proximal ist, wobei der Scheitel (7) der Zinne (6) und die Seitenflanken (8a, 8b) der Zinne (6) mit einer Schicht (9) aus einem dielektrischen Material in der Nähe des Verstärkers (1) überzogen sind,

**dadurch gekennzeichnet, dass** die Zinne durch eine Basis (5a) und einen Vorsprung des Wellenleiters (5) gebildet ist, wobei das die Basis (5a) bildende Material von dem den Vorsprung (5b) bildenden Material verschieden ist.

2. Laser nach Anspruch 1, **dadurch gekennzeichnet, dass** der Boden (10a, 10b) der Zinne (6) mit dem dielektrischen Material in der Nähe des Verstärkers (1) überzogen ist.

3. Laser nach einem der Ansprüche 1 und 2, **dadurch gekennzeichnet, dass** das dielektrische Material SiO$_2$ ist.

4. Laser nach einem der Ansprüche 1 bis 3, **dadurch gekennzeichnet, dass** der Abstand zwischen den beiden Flanken der Zinne (6) in der Nähe des Verstärkers (1) im Bereich zwischen 500 nm und 1100 nm liegt.

5. Laser nach einem der Ansprüche 1 bis 4, **dadurch gekennzeichnet, dass** er einen ersten Modenwandler (11a) und einen zweiten Modenwandler (11b) umfasst, ein jeder in dem Wellenleiter (5) an einem jeweiligen Ende eines Bereichs (Z1) ausgebildet, in dem der Verstärker (1) und der Wellenleiter (5) entlang einer Längsachse (A1) des Wellenleiters (5) gegenüber liegen.

6. Laser nach Anspruch 5, **dadurch gekennzeichnet, dass** ein jeder der ersten und zweiten Modenwandler (11a, 11b) einen Flaschenhals (13a, 13b) bildet, der durch die Flanken (8a, 8b) der Zinne (6) definiert ist.

7. Laser nach einem der vorhergehenden Ansprüche, **dadurch gekennzeichnet, dass** er einen Modulator umfasst, der geeignet ist, eine Information an einem Ausgang des Lasers zu codieren.

8. Laser nach einem der vorhergehenden Ansprüche, **dadurch gekennzeichnet, dass** im Bereich eines Ausgangs des Lasers der Abstand zwischen den Seitenflanken (8a, 8b) bis zur Unterbrechung des Vorsprungs in einer von dem Verstärker (1) abgewandten Richtung abnehmend ist, um einen adiabatischen Übergang und eine schrittweise Eingrenzung einer optischen Mode lediglich in Richtung der Basis (5a) zu realisieren.

9. Laser nach einem der vorhergehenden Ansprüche, **dadurch gekennzeichnet, dass** der Vorsprung (5b) durch eine Aufschichtung aus einer ersten Schicht (5c) aus Dielektrikum, die in direktem Kontakt mit der Basis (5a) ist, und einer zweiten Schicht (5d) aus einem Material, ausgewählt aus amorphem Silicium, polykristallinem Silicium, Si$_3$N$_4$, SiN$_x$, Al$_2$O$_3$, TiO$_2$, gebildet ist.

10. Verfahren zur Herstellung eines Lasers nach Anspruch 1, **dadurch gekennzeichnet, dass** es die folgenden Schritte umfasst:

- Ausbilden des Wellenleiters (5) auf einem ersten Substrat (17) und wenigstens teilweises Überziehen des Wellenleiters (5) im Bereich des Scheitels (7) und der Flanken (8a, 8b) der Zinne (6) mit einer ersten Schicht aus dielektrischem Material (9a),
- Ausbilden, auf einem zweiten Substrat (18), einer Aufschichtung aus Schichten, die dazu bestimmt sind, die Heterostruktur vom Typ III-V zu bilden, wobei der Scheitel der Aufschichtung mit einer zweiten Schicht aus dielektrischem Material (9b) überzogen ist,
- Übertragen des ersten Substrats (17) auf das zweite Substrat (18) und Aufkleben, durch molekulares Kleben, der ersten Schicht aus dielektrischem Material (9a) auf die zweite Schicht aus dielektrischem Material (9b),
- Entfernen des zweiten Substrats (18),
- Begrenzen der Heterostruktur vom Typ III-V des Verstärkers (1).

11. Herstellungsverfahren nach Anspruch 10, **dadurch gekennzeichnet, dass** der Schritt des molekularen Klebens ein SiO$_2$-auf-SiO$_2$-Klebeschritt ist.


**Claims**

1. A laser comprising:

    - a III-V heterostructure type amplifier (1), designed to generate photons,
    - a waveguide (5), optically coupled to the amplifier (1), and comprising a hat-shaped cross-section (6) the top (7) of which is proximal to the amplifier (1), the top (7) of the hat (6) and the lateral sides (8a, 8b) of the hat (6) being covered with a dielectric material layer (9) in the vicinity of the amplifier (1),

    **characterized in that** the hat is formed by a base (5a) and a protrusion of the waveguide (5), the material forming the base (5a) being different from the material forming the protrusion (5b).

2. The laser of claim 1, **characterized in that** the bottom (10a, 10b) of the hat (6) is covered with the dielectric material in the vicinity of the amplifier (1).

3. The laser of any of claims 1 and 2, **characterized in that** the dielectric material is SiO$_2$.

4. The laser of any of claims 1 to 3, **characterized in that** the distance separating the two sides of the hat (6) in the vicinity of the amplifier (1) ranges between 500 nm and 1100 nm.

5. The laser of any of claims 1 to 4, **characterized in that** it comprises a first mode transformer (11a) and a second mode transformer (11b), each formed in the waveguide (5) at a respective end of an area (Z1) where the amplifier (1) and the waveguide (5) face each other along a longitudinal axis (A1) of the waveguide (5).

6. The laser of claim 5, **characterized in that** each of the first and second mode transformers (11 a, 11 b) forms a bottleneck (13a, 13b) defined by sides (8a, 8b) of the hat (6).

7. The laser of any of the foregoing claims, **characterized in that** it comprises a modulator capable of coding information at an exit of the laser.

8. The laser of any of the foregoing claims, **characterized in that** at an exit of the laser, the distance separating the lateral sides (8a, 8b) decreases to interrupt the protrusion in a direction opposite to the amplifier (1) to perform an adiabatic transition and a progressive confinement of an optical mode towards the base (5a) only.

9. The laser of any of the foregoing claims, **characterized in that** the protrusion (5b) is formed by a stack of a first dielectric layer (5c) in direct contact with the base (5a) and of a second layer (5d) of a material selected from among amorphous silicon, polysilicon, Si$_3$N$_4$, SiN$_x$, Al$_2$O$_3$, TiO$_2$.

10. A method for manufacturing the laser of claim 1, **characterized in that** it comprises the steps of:

    - forming the waveguide (5) on a first substrate (17) and at least partially covering the waveguide (5) at the top (7) and on the sides (8a, 8b) of the hat (6) with a first layer of a dielectric material (9a),
    - forming on a second substrate (18) a stack of layers intended to form the III-V heterostructure type, the top of the stack being covered with a second dielectric material layer (9b),
    - placing the first substrate (17) on the second substrate (18), and bonding by molecular bonding the first dielectric material layer (9a) to the second dielectric material layer (9b),
    - removing the second substrate (18),
    - delimiting the III-V heterostructure type amplifier (1).

11. The manufacturing method of claim 10, **characterized in that** the molecular bonding step is a SiO$_2$-SiO$_2$ bonding step.

Figure 1

Figure 2

Figure 3

Figure 4

Figure 5

Figure 6

Figure 7

Figure 8

Figure 9

Figure 10

Figure 11

Figure 12

Figure 13

Figure 14

Figure 15

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **W. FANG et al.** A distributed Bragg Reflector Silicon Evanescent Laser. *IEEE Photonics Technology Letters,* 15 Octobre 2008, vol. 20 (20

- **B. BEN BAKIR et al.** Electrically driven hybrid Si/III-V lasers based on adiabatic mode transformers. *PROCEEDING OF SPIE,* 01 Avril 2010, vol. 7719